(19) **Europäisches Patentamt / European Patent Office / Office européen des brevets**

(11) **EP 2 768 141 A1**

(12) # EUROPEAN PATENT APPLICATION

(43) Date of publication:
**20.08.2014 Bulletin 2014/34**

(51) Int Cl.:
***H03K 19/0944*** *(2006.01)*

(21) Application number: **13155542.7**

(22) Date of filing: **15.02.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Technische Universität Darmstadt 64285 Darmstadt (DE)**

(72) Inventors:
- **Ganesan, Ramkumar 64293 Darmstadt (DE)**
- **Glesner, Prof. Dr. Manfred 64354 Reinheim (DE)**

(74) Representative: **Stumpf, Peter c/o TransMIT GmbH Kerkrader Strasse 3 35394 Gießen (DE)**

(54) **Active loads, especially for use in inverter circuits**

(57)    The invention relates to actives loads, especially for, but not limited to use in inverter circuits. The proposed active load comprises two transistors connected in an inventive way. The transistors may be PMOS or NMOS-organic transistors or transistors based on conventional silicon technologies or others.

**Description**

The invention relates to actives loads, especially for, but not limited to use in inverter circuits. The proposed active load uses an improved load structure containing two transistors connected to each other in an inventive way.

Organic circuits are PMOS only circuits due to inferior performance of NMOS transistors. Inverters are the fundamental circuit blocks to realize any functionality. For better performance, inverters must have large gain, good noise margin, wide output swing and low power consumption and at the same time should be robust to threshold voltage (Vt) variation. The proposed active load and the resulting circuit topology, when used in an inverter circuit, provides higher gain, consumes less power and is also robust to threshold voltage (Vt) while providing more or less the same swing and noise margin as existing circuits.

**State of the Art/Prior Art**

The state of art includes inverter with a level-shifter, pseudo-D, pseudo-E, diode (enhancement) load and cutoff (depletion) load inverter.

From the state of the art the following documents are cited as examples of the above mentioned inverters and load structures:

1. US patent, 7687807 B2, Koo et al., 03/2010
2. US patent, 2007/0272948 A1, Koo et al., 11/2007
3. US patent, 7952392 B2, Koyama et al., 05/2011
4. US patent, 7030666 B2, Brazis et al., 04/2006
5. US patent, 7663405 B2, Tam, 02/2010
6. Tsung-Ching Huang et al., "Pseudo-CMOS: A Design Style for Low-Cost and Robust Flexible Electronics", IEEE Trans. On Electron Devices, Vol. 58, No.1, 2011

An inverter is a basic building block for any microelectronic circuits. It is used as a switch for digital applications and as an amplifier in analog applications. A PMOS organic inverter consists of minimum two organic transistors i.e. a load and a driver transistor. The input is connected to the gate of the driver transistor and output is taken from the drain of driver transistor.

The performance of an inverter is determined by the ratio of W/L of load and driver transistor, and the type of load. However, due to area-concern, one cannot increase the inverter performance beyond a limit using transistor sizing. Further improvement in performance can only be achieved through better load structure.

Depending on how the gate of load transistor is connected there are three basic types of load:

> When connected to output i.e. Vgs = 0, it is denoted as cut-off load
> When connected to drain it is denoted as diode or saturated load
> When connected to a bias voltage, it is denoted as biased load

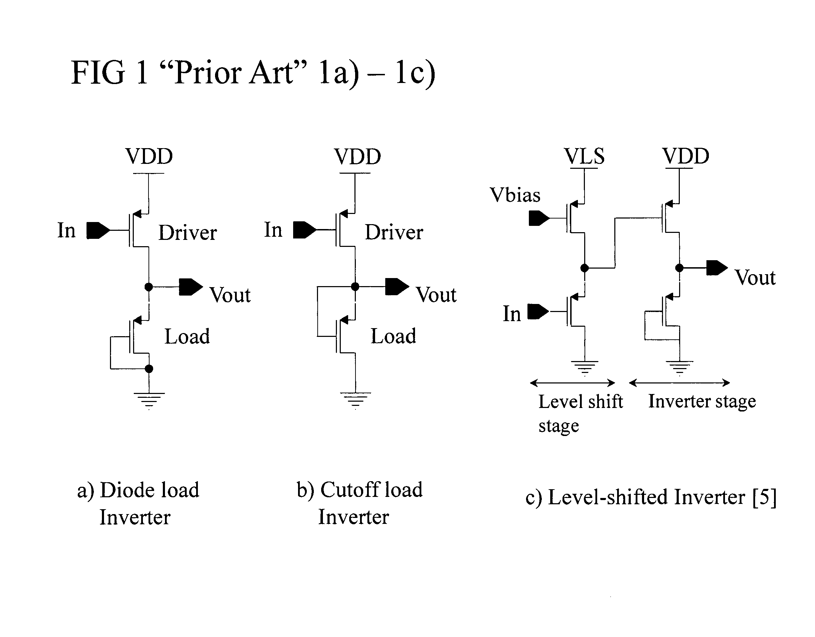

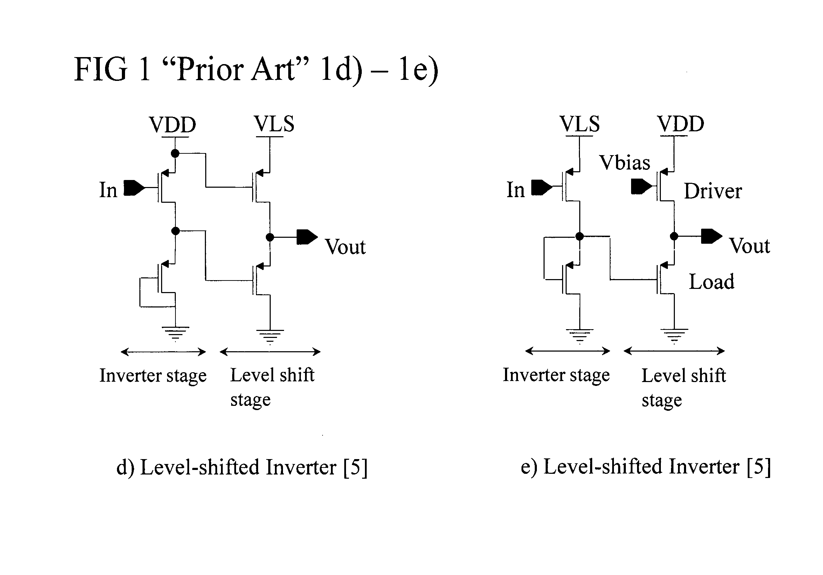

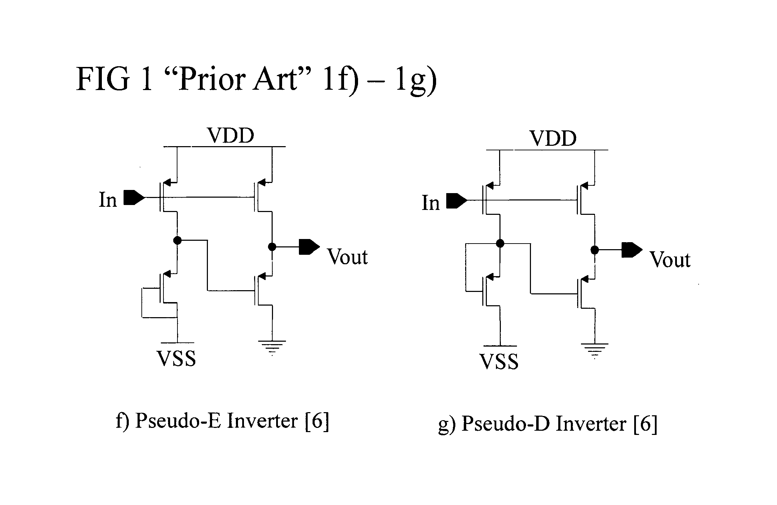

The prior art includes the cut-off load inverter [1,2,3], diode load inverter [1,2], variants of biased load inverters like level-shifted inverter [4] and Pseudo-D, Pseudo-E inverters [6]. Other techniques either involve additional processing/manufacturing steps like dual gate load transistor [2] or use passive components like bootstrap load inverter [3]. See Fig. 1 "Prior Art" a) to g) below.

The State of the Art or Prior Art circuits -and their corresponding load structure- have the following disadvantages:

1) Cutoff load inverter: Has good gain and noise margin. But since the load transistor works only on the threshold voltage (Vt), any changes to Vt drastically affects the output. So it is highly reliable when there is a threshold voltage variation.
2) Diode load inverter: Is not very much affected by Vt variations but has very low gain and noise margin.
3) Level-shifted inverters: Has slightly improved performance compared to the inverter only, i.e. without any level shifter. But it requires 4 transistors instead of 2.
4) Pseudo-D & Pseudo -E: Pseudo-D has better performance than Pseudo-E. Compared to cut-offload inverter, Pseudo-D provides only a slightly better gain.

To summarise, Pseudo-D and cutoff load inverters have better gain and noise margin out of all the existing circuits. However, Pseudo-D inverters require 4 OTFTs and additional supply voltage, whereas cut-off load inverters are unreliable taking into account the Vt variations associated with OTFTs.

**Task of the invention**

Therefore it is the task of the invention to reduce the disadvantages in the prior art and propose a favourable active load, especially for usage, but not restricted to usage in an inverter circuit.

Especially in the field of use of an inverter, it would be desirable to have much better gain, noise margin but at the cost of less transistors and at the same time being more robust to Vt variations.

This task is solved with the active load proposed according to claim 1 and the following claims. Further favorable embodiments are shown below.

The invention relates to electronic devices comprising organic semiconductors that are primarily P-type devices. This is also applicable to all PMOS only electronic circuits using other semiconductor materials like Si, amorphous silicon etc. Though N-type devices are producable, their performance is far inferior compared to P-type organic thin film transistors (OTFTs). Their stability is also inferior compared to P-type devices. P-and N- type OTFTs use different organic materials. Complementary OTFT circuits usually need to incorporate slower and less reliable N-type OTFT and also involve additional processing steps.

Considering the above reasons, organic CMOS devices is not a viable option. So, the organic circuit design for the usage of the invention within an inverter circuit was continued with only PMOS devices.

This is analogous to amorphous-Si devices in the sense that they are only N-type and CMOS devices using a:Si is not feasible. The OTFTs are mostly depletion type devices (normally on). Doping of organic semiconductors poses a bigger challenge and so it is difficult to produce enhancement type (normally off) devices. Nevertheless it could be done, but the reliability of such a device is a matter of concern too.

**Detailed description of the invention**

The cutoff load has better gain and noise margin. But since the cutoff load transistor operates on Vgs eff = 0 - Vt, the threshold variations are completely translated to variations in Vgs eff. So cutoff load inverters are highly unreliable.

In case of diode load, Vgs eff = Vgs - Vt ; Vgs = 0 - Vout. Here Vout is larger than Vt and so for any change in Vt, there is less variation on Vgs eff. This is the main reason why diode load inverters are more reliable than cutoff load inverters. But due to large Vgs eff, power consumption is increased. Moreover, this load structure reduces the output resistance and so gain is reduced ($A_V$ = -gm driver/gm load).

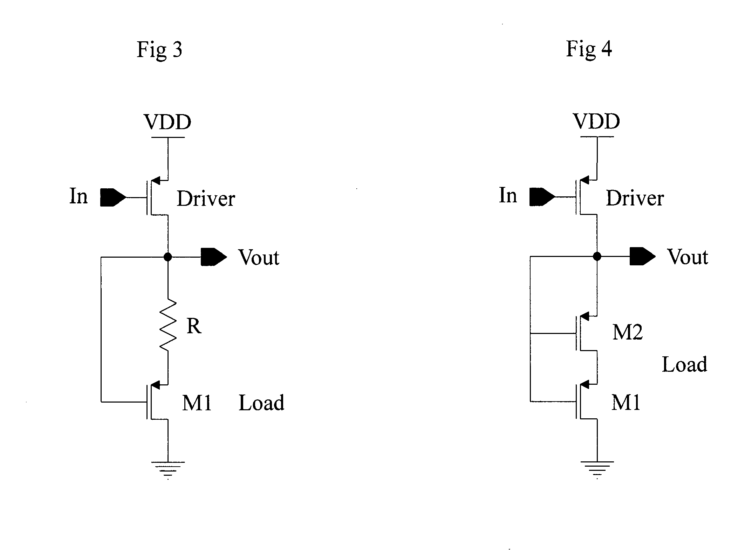

A better solution can be achieved if we are able to use a cutoff load but with a mechanism to reduce variation in Vgseff for a given Vt variation. This is achieved by connecting a resistor between G and S of the depletion load as shown in Fig 3.

$$\text{Vgs eff} = Vg - Vs - Vt; \quad Vg = Vs + V_R; \quad \text{Vgs eff} = V_R - Vt$$

Here $V_R$ is the voltage drop across R and it reduces the dependence of Vgseff on Vt. For operation of transistor, $V_R$ should be less than Vt.

Now, if Vt decreases, Vgseff increases, current increases and $V_R$ increases proportionally and Vgseff reduces proportionally thus compensating the previous increase. This is also valid for increase in Vt. Thus the proposed load is more robust to Vt variations.

Surprisingly the resistor in Fig. 3 could successfully be replaced by an active load (M2) i.e. an OTFT in a cut-off configuration or diode-connected configuration. When using diode connected OTFT, the W/L must be much smaller than M1 and moreover it provides less gain compared to that of a cut-off transistor as M2. Surprisingly we could also use successfully both M1 and M2 as cut-off transistors (Fig. 4 and Fig. 6a). Surprisingly, comparable results (advantages) were also found for the embodiments "diode-conneted transistor inside cut-off transistor" (Fig. 6b), "diode-connected transistor inside diode-connected transistor" (Fig. 6c) and "cut-off transistor inside diode-connected transistor" (Fig. 6d) of the invention.

The advantages of the proposed inventive circuit with the proposed inventive active load are, as follows:

- uses only a single additional transistor compared to 2 additional transistors required by Pseudo-D inverter.
- uses less transistors than level shifted inverters and Pseudo-D, Pseudo - E
- has a higher gain that is approx. 75% more than the best existing circuit (Pseudo-D inverter)
- has more or less same noise margin, output swing as the best existing circuits (Pseudo-D and cutoff)
- consumes less power compared to all of the existing related circuits
- is more robust to Vth variation.

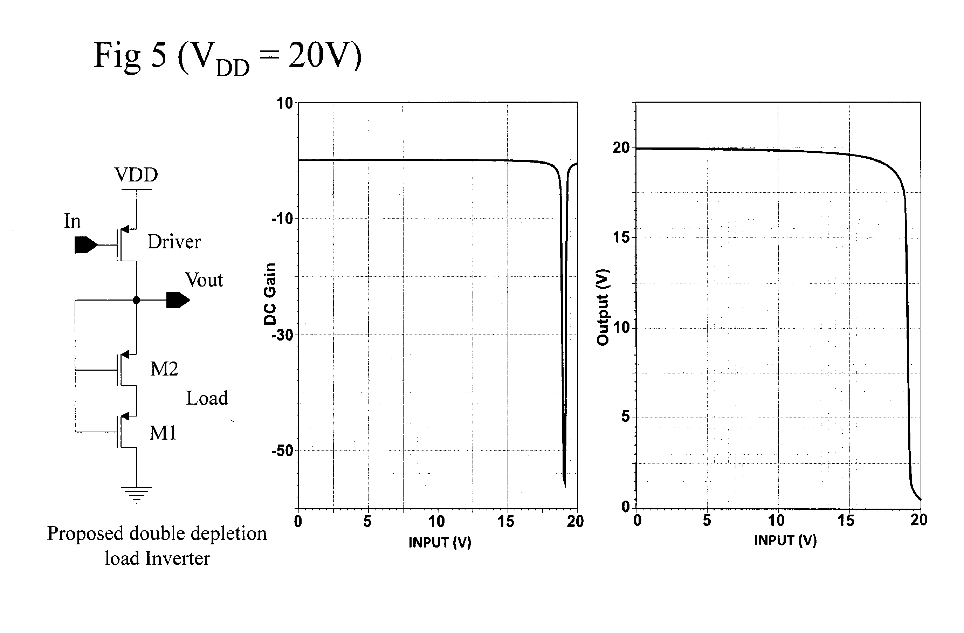

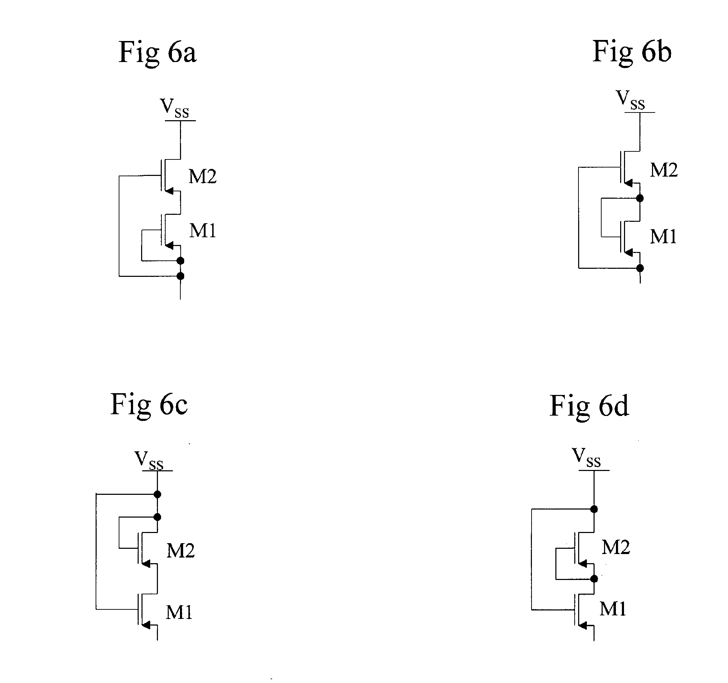

See Fig. 5 for results of the novel active load, in the application form of "cut-off transistor inside cut-off transistor", when used in an inverter circuit. Comparable or slightly inferior results (advantages) were found for other embodiments namely "diode-connected transistor inside cut-off transistor" (Fig. 6b), "diode-connected transistor inside diode-connected transistor" (Fig. 6c) and "cut-off transistor inside diode-connected transistor" (Fig. 6d) of the invention.

In all those embodiments 6a - 6d the first transistor (M1) is connected with its source to the output terminal. An in all those embodiments the drain of the first transistor M1 is connected to the source of the second transistor M2.

In Fig. 6a and 6b the first transistor M1 is connected between the source and gate terminal of the second transistor M2. While the second transistor M2 in 6a and 6b is in a "cut-off"-load arrangement, meaning that its gate terminal is connected to the source of the first transistor M1, the first transistor M1 is also in the "cut-off"-load arrangement in Fig. 6a, but is in the "diode-conneted"-load arrangement, meaning that its gate is connected to its drain, in Fig. 6b.

In Fig. 6c and 6d the second transistor M2 is connected between the gate and drain terminal of the first transistor M1.

While the first transistor (M1) is in 6c and 6d in a "diode-connected"-load arrangement, meaning that its gate is connected to the drain of the second transistor M2, the second transistor M2 is also in the "diode-connected"-load arrangement in Fig. 6c, meaning that its gate is connected to its drain, but is in the "cut-off"-load arrangement in Fig. 6d, meaning, that its gate is connected to its source.

The novel active load can also be used

- to realise plethora of digital gates like NAND, NOR,XOR, AND, OR,
- as amplifier load like in differential amplifiers and operational amplifiers.

In yet another embodiment the active load is realized with enhancement type transistors.

In a further embodiment cascading of 2 or more transistors can be done for the inner transistors namely M2 in case of Fig 6c and d, M1 in case of Fig 6a and b.

This invention is not limited to organic electronics but can also be applied to other semiconductor technologies like amorphous silicon, silicon etc. wherever the circuit is monotype (either P or N type only).


**Claims**

1.   An active load, usable as load section to a corresponding input section within an electronic circuit, where the active load comprises a first (M1) and second transistor (M2), of which the first transistor is connected to the output and the first transistor is connected via its drain to the second transistor.

2.   Active load according to claim 1, **characterized in that** the arrangement is that, that the first transistor (M1) is connected between the gate/source terminals of the second transistor (M2) or the second transistor (M2) is connected between the gate/drain terminals of the first transistor (M1).

3.   Active load according to one of the preceding claims, **characterized in that** the second transistor (M2) is in a "cut-off"-load arrangement, meaning that its gate terminal is connected to the source of the first transistor (M1), and the first transistor (M1) is also in the "cut-off"-load arrangement or is in the "diode-connected"-load arrangement, meaning that its gate is connected to its drain,
or
the first transistor (M1) is in
a "diode-connected"-load arrangement, meaning that its gate is connected to the drain of the second transistor (M2), and the second transistor (M2) is also in the "diode-connected"-load arrangement, meaning that its gate is connected to the drain of the second transistor (M2) or is in the "cut-off"-load arrangement, meaning, that its gate is connected to its source.

4.   Active load according to one of the preceding claims, **characterized in that** the transistors are of the depletion type.

5.   Active load according to one or all of claim 1 to 3, **characterized in that** one transistor is of the enhancement and one is of the depletion type.

6.   Active load according to one of the preceding claims, **characterized in that** at least one of the transistors is an organic, or silicon based or PMOS or NMOS transistor.

7.   Active load according to one of the preceding claims, characterized that the load comprises further passive and/or even active electronic devices, like resistances etc. between the drain of the first transistor (M1) and the source of the second transistor (M2).

8. A digital circuit, such as an inverter, NAND, NOR, XOR, or other logic device, comprising one or more of the active loads according to one of the preceding claims 1 to 7.

9. An analog circuit, such as an inverter, amplifier, differential amplifier, operational amplifier or other analog device, comprising one or more of the active loads according to one of the preceding claims 1 to 7.

# FIG 1 "Prior Art" 1a) – 1c)

EP 2 768 141 A1

a) Diode load
Inverter

b) Cutoff load
Inverter

c) Level-shifted Inverter [5]

# FIG 1 "Prior Art" 1d) – 1e)

d) Level-shifted Inverter [5]

e) Level-shifted Inverter [5]

FIG 1 "Prior Art" 1f) – 1g)

f) Pseudo-E Inverter [6]          g) Pseudo-D Inverter [6]

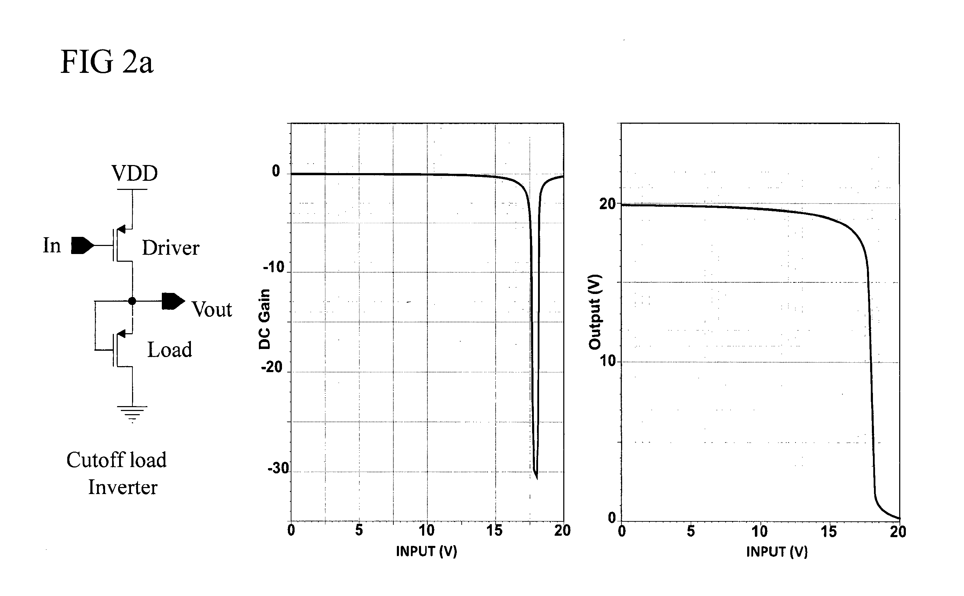

# FIG 2a

EP 2 768 141 A1

VDD

In ▶ Driver

● ▶ Vout

Load

Cutoff load
Inverter

EP 2 768 141 A1

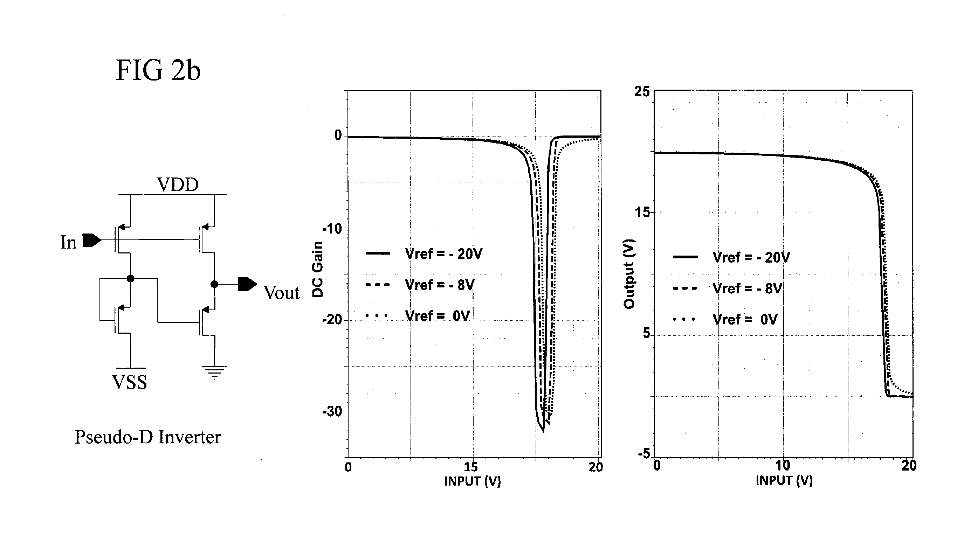

FIG 2b

Pseudo-D Inverter

Fig 3

Fig 4

# Fig 5 ($V_{DD}$ = 20V)

Proposed double depletion
load Inverter

Fig 6c

Fig 6a

Fig 6d

Fig 6b

Europäisches
Patentamt

European
Patent Office

Office européen
des brevets

**EUROPEAN SEARCH REPORT**

Application Number

EP 13 15 5542

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 221 973 A1 (SHARP KK [JP]) 25 August 2010 (2010-08-25) * figure 25 * ----- | 1,4-9 | INV. H03K19/0944 |
| X | US 6 664 842 B1 (POBANZ CARL WALTER [US]) 16 December 2003 (2003-12-16) * figure 1b * ----- | 1,4-9 | |

TECHNICAL FIELDS
SEARCHED      (IPC)

H03K

~~The present search report has been drawn up for all claims~~

| Place of search | Date of completion of the search | Examiner |
|---|---|---|
| Munich | 14 August 2013 | Santos, Paulo |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P04C01)

Europäisches
Patentamt

European
Patent Office

Office européen
des brevets

Application Number

EP 13 15 5542

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1

☐ The present supplementary European search report has been drawn up for those parts of the European patent application which relate to the invention first mentioned in the claims (Rule 164 (1) EPC).

**Europäisches Patentamt**
**European Patent Office**
**Office européen des brevets**

**LACK OF UNITY OF INVENTION**
**SHEET B**

Application Number

EP 13 15 5542

The Search Division considers that the present European patent application does not comply with the requirements of unity of invention and relates to several inventions or groups of inventions, namely:

1. claim: 1

   Active load comprising a first and second transistor, of which the first transistor is connected to the output and the first transistor is connected via its drain to the second transistor.
   ---

2. claims: 1(completely); 2(partially)

   Active load comprising a first and second transistor, of which the first transistor is connected to the output and the first transistor is connected via its drain to the second transistor and is connected between the gate and source terminals of the second transistor.
   ---

3. claims: 1(completely); 2(partially)

   Active load comprising a first and second transistor, of which the first transistor is connected to the output and the first transistor is connected via its drain to the second transistor and the second transistor is connected between the gate and drain terminals of the first transistor.
   ---

4. claims: 1(completely); 3(partially)

   Active load comprising a first and second transistor, of which the first transistor is connected to the output and the first transistor is connected via its drain to the second transistor and the second transistor is in a "cut-off"-load arrangement, meaning that its gate terminal is connected to the source of the first transistor, and the first transistor is also in the "cut-off"-load arrangement.
   ---

5. claims: 1(completely); 3(partially)

   Active load comprising a first and second transistor, of which the first transistor is connected to the output and the first transistor is connected via its drain to the second transistor and the second transistor is in a "diode-connected"-load arrangement, meaning that its gate is connected to its drain.
   ---

6. claims: 1(completely); 3(partially)

   Active load comprising a first and second transistor, of

Europäisches
Patentamt

European
Patent Office

Office européen
des brevets

**LACK OF UNITY OF INVENTION**
**SHEET B**

Application Number

EP 13 15 5542

The Search Division considers that the present European patent application does not comply with the requirements of unity of invention and relates to several inventions or groups of inventions, namely:

which the first transistor is connected to the output and the first transistor is connected via its drain to the second transistor and the first transistor is in a "diode-connected"-load arrangement, meaning that its gate terminal is connected to the drain of the second transistor, and the second transistor is also in the "diode-connected"-load arrangement, meaning that its gate is connected to the drain of the second transistor.

- - -

7. claims: 1(completely); 3(partially)

Active load comprising a first and second transistor, of which the first transistor is connected to the output and the first transistor is connected via its drain to the second transistor and the first transistor is in a "diode-connected"-load arrangement, meaning that its gate terminal is connected to the drain of the second transistor, and the second transistor is in the "cut-off"-load arrangement, meaning that its gate is connected to its source.

- - -

## ANNEX TO THE EUROPEAN SEARCH REPORT
## ON EUROPEAN PATENT APPLICATION NO.

EP 13 15 5542

This annex lists the patent family members relating to the patent documents cited in the above-mentioned European search report.
The members are as contained in the European Patent Office EDP file on
The European Patent Office is in no way liable for these particulars which are merely given for the purpose of information.

14-08-2013

| Patent document cited in search report | | Publication date | Patent family member(s) | | Publication date |
|---|---|---|---|---|---|
| EP 2221973 | A1 | 25-08-2010 | CN | 101868919 A | 20-10-2010 |
| | | | EP | 2221973 A1 | 25-08-2010 |
| | | | JP | 5048081 B2 | 17-10-2012 |
| | | | US | 2010253393 A1 | 07-10-2010 |
| | | | WO | 2009081619 A1 | 02-07-2009 |
| US 6664842 | B1 | 16-12-2003 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7687807 B2, Koo
- US 20070272948 A1, Koo
- US 7952392 B2, Koyama
- US 7030666 B2, Brazis
- US 7663405 B2, Tam

### Non-patent literature cited in the description

- **TSUNG-CHING HUANG et al.** Pseudo-CMOS: A Design Style for Low-Cost and Robust Flexible Electronics. *IEEE Trans. On Electron Devices,* 2011, vol. 58 (1